# EUROPEAN PATENT APPLICATION

(11) **EP 2 330 653 A1**
(43) Date of publication of application: **08.06.2011**
(21) Application number: 09815868.6
(22) Date of filing: 18.09.2009
(51) Int. Cl.: H01L 51/50, H05B 33/10

(54) **COMPOSITE ORGANIC ELECTROLUMINESCENT MATERIAL**

(30) Priority: 24.09.2008 JP 2008244658
(71) Applicant: Idemitsu Kosan Co., Ltd., Chiyoda-ku Tokyo 100-8321 (JP)
(72) Inventor: MATSUNAMI, Hidehiro, Sodegaura-shi Chiba 299-0293 (JP); KADOI, Yasunori, Sodegaura-shi Chiba 299-0293 (JP); HOSOKAWA, Chishio, Sodegaura-shi Chiba 299-0293 (JP); TANAKA, Yoshikazu, Sodegaura-shi Chiba 299-0293 (JP)
(74) Representative: Gille Hrabal Struck Neidlein Prop Roos
(86) International application number: PCT/JP2009/004716
(87) International publication number: WO 2010/035446

(57) **Abstract**

A composite organic electroluminescent material includes particles that include two or more materials, the two or more materials being bonded and including a first material and a second material.

## Description

### TECHNICAL FIELD

The invention relates to an organic electroluminescent (EL) material that includes a plurality of materials and may suitably be used for flash evaporation, and a method of producing the same.

### BACKGROUND ART

Patent Document 1 states that vacuum physical deposition is normally used to deposit a thin film of an organic material used for an OLED device, for example. However, an organic material may often be decomposed when the organic material is maintained at the desired vaporization temperature (or a temperature around the desired vaporization temperature) for a long time. In particular, when a sensitive organic material is subjected to a higher temperature, the particle structure of the material may change, so that the properties of the material may change.
In normal vacuum vapor deposition, an organic material is placed in an evaporation source (crucible), and heated at a high temperature under vacuum. The material is evaporated by heating, and deposited on a substrate. Therefore, since the entire material contained in the crucible is continuously heated at a high temperature, deterioration of the material is accelerated. Moreover, since the material is evaporated under vacuum, it is difficult to control the evaporation direction of the material. This makes it necessary to improve the utilization efficiency of the material that actually contributes to deposition.
In view of the above situation, flash evaporation has attracted attention.

Patent Document 2 discloses a method of producing an organic thin film of an organic thin film electroluminescence device using flash evaporation.
In flash evaporation, a material is supplied to a heated evaporation source, and rapidly evaporated to deposit a thin film of an organic compound (organic thin film) on the surface of a substrate.
Specifically, an organic thin film material placed in a material container is dropped into a heating/evaporating section heated at 300 to 600°C via a screw section, so that the material is evaporated instantaneously. The evaporated material passes through a heating duct, and is discharged toward a substrate, so that the organic material is deposited on the substrate. Since the material that has been dropped into the heating/evaporating section is heated, the material is not heated continuously. Moreover, since the travel direction of the heated/sublimed material can be controlled, the material can be efficiently used to deposit a film.

An organic EL device normally has a structure in which an emitting layer that includes an emitting organic compound (hereinafter referred to as "emitting material") is sandwiched between a pair of electrodes. Electrons are injected from one of the electrodes, and holes are injected from the other electrode. Light is emitted when the electrons and the holes recombine in the emitting layer. An organic EL device normally has a configuration in which an anode, a hole transporting layer, an emitting layer, an electron transporting layer, and a cathode are sequentially stacked. The emitting layer, the hole transporting layer, and the electron transporting layer are formed by depositing an organic material to a thickness of several to several tens of nanometers. The emitting layer is normally formed using a material prepared by mixing a small amount of doping material (fluorescent material or phosphorescent material) with a host material that generates excitons.

Patent Document 1 discloses a deposition apparatus and a deposition method that reduce the period of time in which a deposition material is subjected to a high temperature. The deposition apparatus disclosed in Patent Document 1 includes a manifold having an opening. A vaporized organic material is introduced into the manifold, and supplied to and deposited on a substrate via the opening.

Patent Documents 2 and 3 disclose a method of producing an organic thin film of an organic thin film electroluminescence device using flash evaporation. In Patent Document 2, a material mixture prepared using an agate mortar or the like is supplied to a heated evaporation source, and rapidly evaporated to deposit an organic thin film on the surface of a substrate. When using this method, however, the uniformity of the material may be lost before the material is supplied to the evaporation source. In this case, since the ratio of each material dropped from the feeder changes with time, uniform organic EL devices may not be produced.

### RELATED ART DOCUMENT

### PATENT DOCUMENT

Patent Document 1: JP-T-2000-519904
Patent Document 2: US-A-2007/0248753
Patent Document 3: JP-A-2008-530733

### SUMMARY OF THE INVENTION

In view of the above problems, an object of the invention is to provide a composite organic EL material that includes a plurality of materials and may suitably be used for flash evaporation, and a method of producing the same.

The invention provides the following composite organic EL material and the like.
1. A composite organic electroluminescent material comprising particles that include two or more materials, the two or more materials being bonded and including a first material and a second material.
2. The composite organic electroluminescent material according to 1, wherein the first material is covered with the second material.
3. The composite organic electroluminescent material according to 1 or 2, wherein the first material is a host material, and the second material is a doping material.
4. The composite organic electroluminescent material according to any one of 1 to 3, wherein the first material is selected from anthracene derivatives and naphthacene derivatives, and the second material is selected from aromatic amine derivatives, periflanthene derivatives, and pyrromethene derivatives.
5. The composite organic electroluminescent material according to any one of 1 to 4, the composite organic electroluminescent material having an average particle size of 20 to (540-3σ) µm (where, σ is the standard deviation of the particle size distribution of the composite organic electroluminescent material).
6. The composite organic electroluminescent material according to 5, the composite organic electroluminescent material having an average particle size of 20 to (200-3σ) µm (where, σ is the standard deviation of the particle size distribution of the composite organic electroluminescent material).
7. The composite organic electroluminescent material according to any one of 1 to 4, the composite organic electroluminescent material having an average particle size of 20 to 80 µm.
8. The composite organic electroluminescent material according to any one of 1 to 7, the composite organic electroluminescent material including particles having a particle size of 10 µm or less in an amount of 10 wt% or less.
9. A method of producing a composite organic electroluminescent material comprising reducing a particle size of two or more materials including a first material and a second material, and bonding the two or more materials to obtain particles.
10. A method of producing a composite organic electroluminescent material comprising reducing a particle size of a first material and a second material, and covering the first material with the second material.
11. The method according to 10, wherein the average particle size of the second material is reduced to 3 to 30 µm.
12. The method according to 10 or 11, wherein the first material is covered with the second material using a mechanofusion method.
13. The method according to any one of 9 to 12, further comprising classifying the first material that has been reduced in particle size so that the first material includes particles having a particle size of 10 µm or less in an amount of 10 wt% or less.
14. A deposition method comprising depositing a film using the composite organic electroluminescent material according to any one of 1 to 8.

The invention thus provides a composite organic EL material that includes a plurality of materials and may suitably be used for flash evaporation, and a method of producing the same.

### BRIEF DESCRIPTION OF THE DRAWINGS

FIG. 1A is a view showing a particle in which a first material is covered with a second material.
FIG. 1B is a view showing another particle in which a first material is covered with a second material.
FIG. 1C is a view showing another particle in which a first material is covered with a second material.
FIG. 1D is a view showing a particle in which a first material and a second material are bonded.
FIG. 1E is a view showing another particle in which a first material and a second material are bonded.
FIG. 1F is a view showing another particle in which a first material and a second material are bonded.
FIG. 2 is a view showing a mechanofusion apparatus that may be used for a production method according to one embodiment of the invention.
FIG. 3A is a view showing a flash evaporation apparatus.
FIG. 3B is a view showing a material container and a screw section of the flash evaporation apparatus shown in FIG. 3A.
FIG. 4 is a view showing an organic EL device.
FIG. 5A shows a photograph of a composite organic EL material obtained in Example 1.
FIG. 5B shows a photograph of a composite organic EL material obtained in Example 2.
FIG. 6 is a view showing the particle size distribution of a composite organic EL material obtained in Example 1.

### MODE FOR CARRYING OUT THE INVENTION

### (1) Composite organic EL material

A composite organic EL material (hereinafter may be referred to as "composite material") according to one embodiment of the invention includes particles that include a plurality of materials which are bonded. This means that the plurality of materials are strongly bonded within each particle. The composite organic EL material according to one embodiment of the invention includes particles that include a first material and a second material that covers the first material. This means that the first material is strongly bonded to and covered with the second material within each particle. The plurality of materials preferably include a first material selected from anthracene derivatives and naphthacene derivatives, and a second material selected from aromatic amine derivatives, periflanthene derivatives, and pyrromethene derivatives, and may also include a compound other then these compounds. The composite organic EL material according to one embodiment of the invention includes a material in which the first material is covered with only the second material, and a material in which the first material is covered with the second material and another material.
Note that the composite organic EL material according to one embodiment of the invention may include particles of the first material and/or the second material that are not bonded or covered.

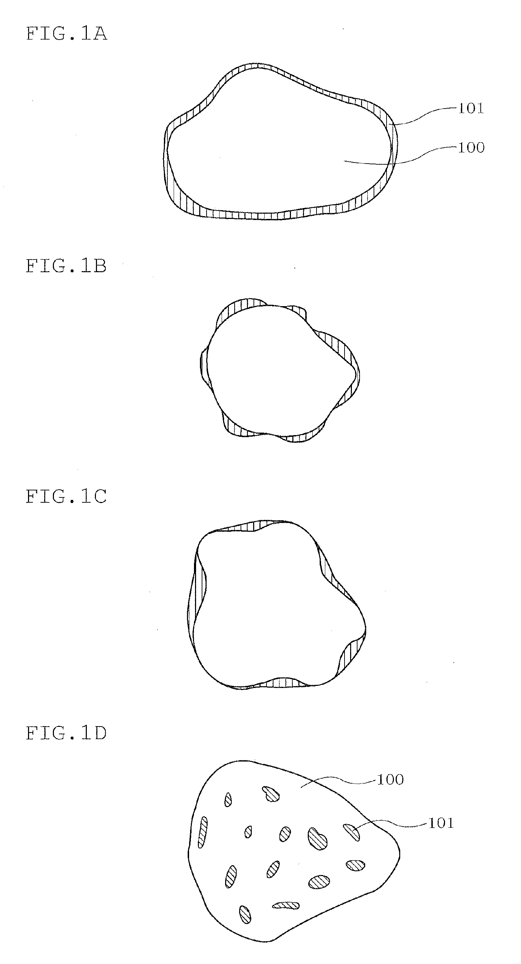

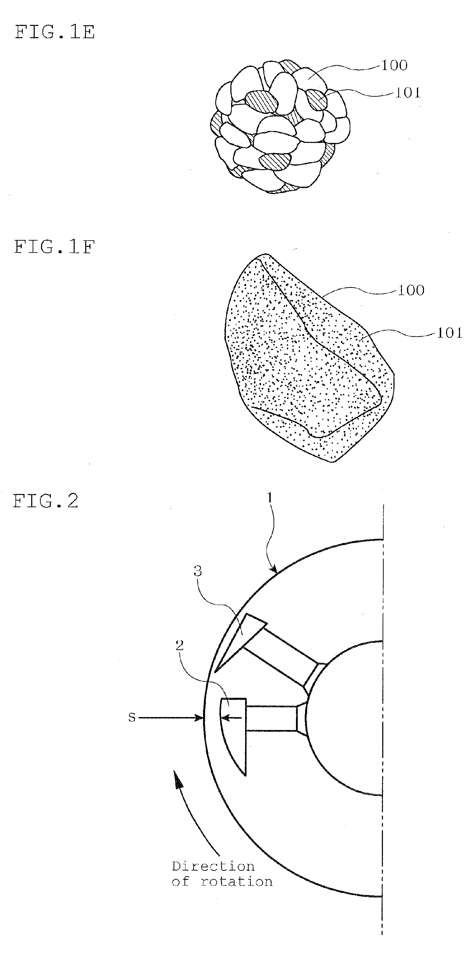

As shown in FIG. 1A, the entire surface of a first material 100 may be covered with a second material 101, or as shown in FIG. 1B, the surface of the first material 100 may be partially covered with the second material 101, or as shown in FiG. 1C, the second material 101 may be present in depressions formed in the surface of the first material 100, for example. As shown in FIGS. 1D to 1F, the first material and the second material may be bonded in a mixed (composite) state. In FIG. 1D, a plurality of particles of the second material are included within a particle of the first material in a state in which the particles of the second material maintain a particle shape. In FIG. 1E, a plurality of particles of the first material and a plurality of particles of the second material are bonded to form a single particle in an incompletely molten state. In FIG. 1F, the first material and the second material are bonded to form a single particle in a dispersed state.
When the composite organic EL material includes three or more materials, the first material is covered with the second material and another material in FIGS. 1A to 1C, and three or more materials are bonded in a mixed state in FIGS. 1D to 1F.

The composite organic EL material according to one embodiment of the invention preferably has an average particle size of 20 to (540-3σ) µm, more preferably 20 to (200-3σ) µm, and particularly preferably 20 to 80 µm. Note that σ is the standard deviation of the particle size distribution of the composite organic electroluminescent material.
Such a composite material has high fluidity, and rarely clogs a screw section of a flash evaporation apparatus.
The average particle size used herein refers to a value measured by laser diffraction (Mie scattering theory). A laser diffraction particle size distribution analyzer (Microtrac MT-3300EXII) may be used to measure the particle size. A sufficient amount of composite material is collected as a sample, and the particle size distribution of the sample is determined. The particle size determined by the Mie scattering theory refers to the length from one end to the other end of the cross section of the particle. The number of particles having each particle size is accumulated in ascending order, and the particle size corresponding to 50% in the particle size distribution is determined to be the average particle size.

When the first material is covered with the second material (see FIGS. 1A to 1C), the first material may have various types of particulate shape. For example, the first material may have an approximately spherical particulate shape, an approximately elliptical particulate shape, an approximately polyhedral particulate shape, or the like.

In a composite material in which a plurality of materials are bonded, or a composite material in which one material is covered with another material, the materials exhibit high adhesion as compared with a mixed material obtained by merely mixing the materials. Therefore, when using the composite material for flash evaporation, the materials are not easily separated during a process up to sublimation. Accordingly, a change in compositional ratio of the materials within a layer occurs to only a small extent.

Materials that may be used for an organic EL device may be used as the materials for the composite material according to one embodiment of the invention. For example, an organic emitting material, a hole transporting/injecting material, an electron transporting/injecting material, or the like may be used. Specifically, a plurality of materials that form a layer of an organic EL device may be used in a uniformly mixed state.

When the first material is covered with the second material, the first material is normally used as the main component, and the second material is normally used as a secondary component. When using the composite material for forming an emitting layer, it is preferable to use a host material and a doping material that form the emitting layer as the first material and the second material, respectively. In this case, if the host material and the doping material are used in a mass ratio of 99.5:0.5 to 70:30, effects (e.g., an improvement in luminous efficiency) due to the dopant are obtained while suppressing concentration quenching. The host material and the doping material are more preferably used in a mass ratio of 95:5 to 85:15. Note that a plurality of dopants may be used.

The host material is preferably a diarylanthracene derivative or a diarylnaphthacene derivative, more preferably a naphthylanthracene derivative, and particularly preferably a naphthylanthracene derivative that includes a polyphenyl group as a substituent, from the viewpoint of the luminous efficiency and the like. Note that term "polyphenyl group" refers to a substituent selected from substituted or unsubstituted biphenyl, terphenyl, quaterphenyl, and quinquephenyl.
The host material is preferably a fused aromatic ring derivative. An anthracene derivative, a naphthacene derivative, a pyrene derivative, a pentacene derivative, or the like is preferable as the fused aromatic ring derivative from the viewpoint of the luminous efficiency and the emission lifetime.
The host material may be a fused polycyclic aromatic compound. Examples of the fused polycyclic aromatic ring compound include naphthalene compounds, phenanthrene compounds, and fluoranthene compounds.
The host material may be a heterocyclic compound. Examples of the heterocyclic compound include carbazole derivatives, dibenzofuran derivatives, ladder-type furan compounds, and pyrimidine derivatives.

The doping material is not particularly limited insofar as the doping material has a doping function, but is preferably an aromatic amine derivative from the viewpoint of the luminous efficiency and the like. A fused aromatic derivative that includes a substituted or unsubstituted arylamino group is preferable as the aromatic amine derivative. Examples of such a compound include pyrene, anthracene, chrysene, and periflanthene that include an arylamino group. It is particularly preferable to use a pyrene compound that includes an arylamino group.
A styrylamine compound is also preferable as the doping material. Examples of the styrylamine compound include a styrylamine, a styryldiamine, a styryltriamine, and a styryltetramine. The term "styrylamine" refers to a compound in which a substituted or unsubstituted arylamine is substituted with at least one arylvinyl group. The arylvinyl group may be substituted. Examples of a substituent for the arylvinyl group include an aryl group, a silyl group, an alkyl group, a cycloalkyl group, and an arylamino group. These substituents may also be substituted. Further examples of the doping material includes pyrromethene derivatives.
A metal complex is also preferable as the doping material. Examples of the metal complex include an iridium complex and a platinum complex.
It is preferable that the host material and the doping material have a molecular weight of 200 to 2000 when used for deposition. It is more preferable that the host material and the doping material have a molecular weight of 200 to 1500. It is still more preferable that the host material and the doping material have a molecular weight of 500 to 1000.

### (2) Flash evaporation

Since the composite material according to one embodiment of the invention has a configuration in which a plurality of materials are uniformly dispersed and strongly bonded (i.e., are not easily separated), the composite material may suitably be used when using a flash evaporation apparatus.

In flash evaporation, a material is supplied to a heated evaporation source, and rapidly evaporated to deposit a thin film of an organic compound (organic thin film) on the surface of a substrate.

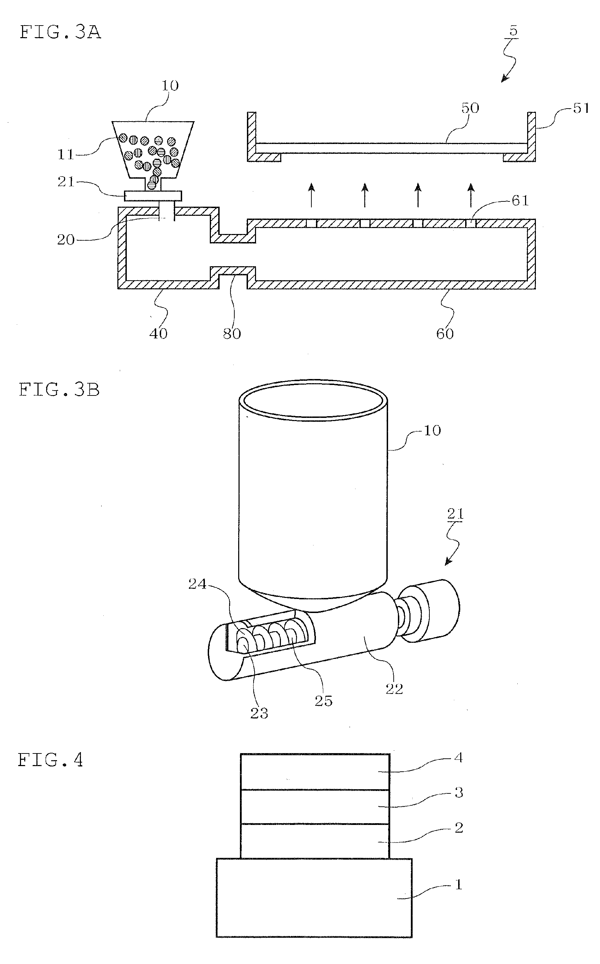

FIG. 3A shows an example of a flash evaporation apparatus. A flash evaporation apparatus 5 shown in FIG. 3A is configured so that a small amount of a material 11 placed in a material container 10 is dropped into a heating/evaporating section 40 from a material supply section 20 via a screw section 21. The heating/evaporating section 40 is heated so that the material 11 that has entered the heating/evaporating section 40 is evaporated instantaneously. The evaporated material passes through a heating duct 80 that connects the heating/evaporating section 40 and a vapor distribution section 60, and is supplied to the vapor distribution section 60. The material in a vapor state is discharged from a vapor discharge section 61 toward a substrate 50 placed on a stage 51. The vapor (material) thus discharged is deposited on the substrate 50.

The heating/evaporating section 40 used for flash evaporation may be a conical basket of a tungsten wire, a molybdenum wire, a tantalum wire, a rhenium wire, a nickel wire, or the like, a crucible made of quartz, alumina, graphite, or the like, a boat made of tungsten, tantalum, or molybdenum, or the like. The composite material is dropped into the evaporation source that is normally heated at 300 to 600°C (preferably 400 to 600°C), and evaporated instantaneously to produce a deposited thin film having an almost identical composition as that of the composite material before being deposited on the surface of the substrate. The flash evaporation conditions are determined depending on the components of the composite material. The evaporation source heating temperature is appropriately selected within the range of 300 to 600°C, the degree of vacuum is appropriately selected within the range of 10⁻⁵ to 10⁻² Pa, the deposition rate is appropriately selected within the range of 5 to 50 nm/sec, the substrate temperature is appropriately selected within the range of -200 to +300°C, and the thickness is appropriately selected within the range of 0.005 to 5 µm.

FIG. 3B shows the material container 10 and the screw section 21. The screw section 21 includes a screw holding section 22, and a screw 23 placed in the screw holding section 22. A small amount of the material 11 contained in the material container 10 is held by the screw 23, and discharged from a discharge port (not shown) by rotating the screw 23. The screw includes a blade 24 and a groove 25. The material is moved to the discharge port through the groove 25 and the space formed between the blade 24 and the screw holding section 22. The screw is rotated when the apparatus has been operated, and the material 11 contained in the material container 10 starts to be dropped in an almost constant amount per unit time (e.g., 4 to 8 mg/min).

An organic material must be deposited on a substrate (e.g., glass substrate or resin substrate) having dimensions of 30 cm × 40 to 73 cm × 92 cm at a deposition rate of about 1 to 10 Å/sec. For example, when depositing a material on a 40×40 cm glass substrate at a deposition rate d of 10 Å/sec, the material is supplied from the evaporation source at a volume (V) of 1.6×10⁻¹¹ m³ per second. Therefore, an almost equal amount of the material is intermittently supplied from the material supply section 20.
In the flash evaporation apparatus disclosed in Patent Document 3, since the opening is formed in the material supply section, it is necessary to take the relationship between the size of the opening and the particle size of the particles into account from the viewpoint of particle technology. It is also necessary to take the relationship between the particle size of the particles and the diameter of the screw section through which the material passes into account.

In order to supply the particles at the constant volume V per second, the particles must not have a volume (particle size) that exceeds the volume V. If a particle having a volume (particle size) that exceeds the volume V is present, the deposition rate momentarily increases to a value larger than d when the particle is supplied, so that the thickness of the film may change. Therefore, the upper limit of the particle size of the particles is determined depending on the deposition rate. For example, when the deposition rate d is set to 10 Å/sec, the particle size of the particles must be equal to or smaller than about 5.4×10⁻⁴ m (540 µm).

If the particle size distribution of the composite organic EL material is a normal distribution, the percentage of particles having a particle size equal to or larger than a value calculated by adding a value obtained by multiplying the standard deviation (σ) of the particle size distribution by three to the average particle size is 0.26% based on the statistical normal distribution theory. If the maximum particle size is referred to as L (=540 µm), the maximum particle size L is a value calculated by adding a value obtained by multiplying the standard deviation (σ) of the particle size distribution by at least three to the average particle size. Therefore, it is desirable that the average particle size of the composite organic EL material be equal to or less than "L-3σ".
The composite organic EL material of the invention is required to be a group of a sufficient amount (number) of particles having a particle size within a given range so that the composite organic EL material can smoothly and stably pass through the screw. Therefore, it is desirable that the particle size of the composite organic EL material conform to a normal distribution or a similar normal distribution. The term "similar normal distribution" refers to a distribution in which the particle size distribution curve does not accurately conform to the normal distribution, but rapidly slopes downward from the peak that indicates the maximum frequency almost in the same manner as in the normal distribution. The term "similar normal distribution" includes a shape in which at least one end of the distribution curve is cut, but excludes a distribution having two or more maximum frequency peaks (e.g., binomial distribution). Note that two or more maximum frequency peaks exclude a peak having a value equal to or less than 50% of the maximum value.

The doping material concentration in the emitting layer is normally about 0.1 to 30 mol%. When the host material and the doping material do not differ in molecular weight and specific gravity to a large extent, the volume ratio of the doping material to the host material is preferably about 0.001 to 0.3. Therefore, the particle size of the doping material must be about 0.1 to 0.9 times the particle size of the host material. When supplying the host material and the doping material using different feeders, the amount of the doping material must be controlled to be 0.001 to 0.3 times the amount of the host material. In this case, the diameter of the material passage area of the screw of the evaporation apparatus and the size of the opening in the material supply section are reduced, and the particle size of the doping material is reduced as compared with the particle size of the host material. The contact surface area between the particles and the apparatus increases as a result of reducing the particle size of the particles, so that the frictional force increases. Therefore, the fluidity of the particles inside the screw decreases, so that the screw section and the opening are clogged. This impairs the amount controllability.

When supplying the host material and the doping material using a single feeder, the ratio of the host particles and the dopant particles that pass through the screw change since a small volume of materials are deposited. Therefore, the compositional ratio of the host material and the doping material supplied to the evaporation source necessarily changes, so that the emission properties of the deposited organic EL device are affected. Moreover, since an external force is applied to the material due to the screw, the dopant particles having a small particle size are easily accumulated in the screw section, but the host particles having a large particle size are easily moved forward by the screw. Therefore, even if the host material and the doping material that differ in average particle size are placed in the container in the desired ratio, it is difficult to maintain the compositional ratio of the mixed material supplied from the material feeder to the evaporation source at a constant value.

However, since the host material and the doping material included in the composite material of the invention are strongly bonded and move together, the compositional ratio can be almost made constant even if the composite material is supplied using a single material feeder. Moreover, it is unnecessary to reduce the size of the opening in the material feeder for the doping material.

According to Kimio Kawakita et al., "Particle Technology (basics)" (Maki Shoten), the fluidity of a powder (particles) is affected by the grain size, the particle shape, the particle size distribution, the surface state, and the like, and the outflow is discontinuous even if the diameter Db and the particle size Dp satisfy the relationship "Db/Dp>10" (pp. 126 to 128). In order to discharge a constant amount of material from the screw section, it is desirable that the particle size be larger than about R/10 (where, R is the diameter of the tube of the apparatus through which the material can pass through).

In order to deposit a film at 1000 Å/min (1.6 nm/sec), the particle has a particle size of 540 µm on the assumption that one particle is discharged from the screw section per second. Even if the particle size is smaller than 540 µm, the diameter of the area of the screw through which the material can pass must be about 540 µm since the volume of the material discharged is identical.

The diameter can be reduced by increasing the rotational speed of the screw so that the moving speed of the material increases. However, the diameter must be set to 100 to 1000 µm in order to stably supply the material.

Since the diameter of the screw section is normally 100 to 1000 µm, it is desirable the particle size be 10 µm or more. Note that the material may include particles having a particle size of 10 µm or less. It is desirable that the material include only a small amount of particles having a particle size of 10 µm or less. Therefore, it is desirable that the composite material include particles having a particle size of 10 µm or less in an amount of 10 vol% or less.

According to Kimio Kawakita et al., "Particle Technology (basics)" (Maki Shoten), the outflow does not become constant even if the diameter Db and the particle size Dp satisfy the relationship "Db/Dp<5". Therefore, it is desirable that the particle size be 200 µm or less. Note that the material may include particles having a particle size of 200 µm or more. It is desirable that the material include only a small amount of particles having a particle size of 200 µm or more.

In the screw section 21 shown in FIG. 3B, the space formed by the groove 25 and the inner wall of the screw holding section 22 has the diameter R.
When the material feeder has a small opening (see Patent Document 3), and the opening is smaller than the space formed by the groove 25 and the inner wall of the screw holding section 22, the diameter of the opening is set to R since the effects of the fluidity of the powder depend on the opening.

The fluidity of the powder can be measured by a dynamic measurement method. For example, the specific energy, the angle of internal friction, the adhesion, and the like may be measured using a powder fluidity analyzer "Powder Rheometer FT4" (manufactured by Sysmex Corporation). A higher value indicates poor fluidity. Note that the specific energy refers to the energy value required for the powder to flow, the angle of internal friction refers to the shear strength of the powder that changes in proportion to the load, and the adhesion is an index of the degree by which the compressed powder is bonded.

If the powder has poor fluidity, the screw section may be clogged by the material, or the amount of material discharged from the screw section may easily change.

### (3) Method of producing composite organic EL material

The composite material of the invention may be produced performing a particle size-reduction step and a bonding/covering step on each material. Note that the particle size-reduction step may be omitted when the raw material has a sufficiently small particle size (e.g., a particle size equal to or smaller than the average particle size described later). A classification step that removes a fine powder from the powder subjected to the particle size-reduction step is optionally performed before the bonding/covering step.

### <Particle size-reduction step>

The particle size of each material is reduced, as required. The particle size of each material may be reduced in a state in which a plurality of materials are mixed. It is preferable to separately reduce the particle size of each material.
The particle size of each material is normally reduced by grinding, but may also be reduced by reprecipitation from a solution, for example.
When reducing the particle size of each material by grinding, a known grinding method may be used. For example, each material is ground using a mortar. It is preferable to use a grinder in order to more finely grind the material. A material that differs in particle size can be obtained by appropriately setting the grinding conditions.

When covering the first material with the second material, it is preferable that the first material have an average particle size of 20 to 80 µm, and the second material have an average particle size of 3 to 30 µm. It is preferable that the second material have a small average particle size in order to obtain a uniform mixed material.

### <Classification step>

A fine powder included in the composite organic EL material may clog the screw section of the flash evaporation apparatus. Therefore, when bonding the second material to the first material, or covering the first material with the second material, it is preferable to classify the first material after the particle size-reduction step in order to remove a fine powder. The first material may be classified by a known method. For example, the first material is classified using a sieve or a multiplex (described later). A fine powder need not necessarily be removed when the second material is not used as the main component. The entire composite material may be classified after producing the composite material (i.e., after performing the bonding step and the covering step).

### <Bonding/covering step>

The first material and the second material optionally subjected to the particle size-reduction step and/or the classification step are mixed (bonded or covered) to obtain a composite organic EL material.
Note that all of the particles need not necessarily be made composite by bonding or covering the material by the following method. The composite organic EL material according to one embodiment of the invention may include the first material and/or the second material that are not bonded or covered.

The first material and the second material may be bonded or covered by an arbitrary method. For example, a melt-mixing method or a mechanofusion method may be used.
The first material is covered with the second material (see FIGS. 1A to 1C) when using the mechanofusion method. The first material and the second material are bonded in a mixed state (see FIGS. 1D to 1F) when using the melt-mixing method.

It is preferable to use the mechanofusion method in order to prevent thermal deterioration in the material.
The mechanofusion method applies strong mechanical energy to a plurality of different particles to cause a mechanochemical reaction to produce composite particles. Note that a mechanochemical reaction is not indispensable insofar as composite particles (e.g., covered particles) can be obtained. When using the mechanofusion method, a method and an apparatus for mechanically rubbing the materials to produce composite particles are not particularly limited.
When producing composite particles (composite material) using the mechanofusion method, it is preferable to use an apparatus that can apply a shear force that efficiently rubs one material against the surface of the other material to effect bonding or covering. Examples of such an apparatus include a mechanofusion apparatus, a ball mill, a stirred mill, a planetary mill, a high-speed rotary grinder, a jet mill, a shear mill, a roller mill, and the like. It is preferable to use a mechanofusion apparatus, a ball mill, or a shear mill.

A mechanofusion apparatus (FIG. 2) that can efficiently produce the composite material according to one embodiment of the invention is described below.
First, the powders are immobilized on the inner wall of the rotating container due to a centrifugal force. The powders are momentarily compacted by an inner piece 2 secured on the center shaft. The powders are then scraped off by a scraper 3. These operations are repeated at a high speed so that composite particles are produced due to the compaction effect and the shear effect. As a result, a mixed material is obtained as aggregates in which the particles are bonded due to the mechanofusion phenomenon. The particles included in the mixed material thus produced exhibit high adhesion as compared with a mixed material produced by a known method (i.e., aggregates formed by electrostatic attraction force or Van der Waals force).

As shown in FIG. 2, the raw material is added to a casing 1, and the casing 1 is rotated so that the raw material is pressed against the inner circumferential wall of the casing due to centrifugal force. A shear force is applied between the inner piece 2 and the casing 1 so that the second material adheres to the surface of the first material. The raw material that has been modified (bonded) between the inner circumferential wall of the casing 1 and the inner piece 2 is scraped off by the scraper 3 secured on the rear side of the inner piece 2, and a shear force is applied again. The casing 1 is cooled in order to prevent an abnormal increase in temperature due to frictional heat. Specifically, a compression effect, a shear effect, and a removal effect can be applied to the powder particles using the rotating casing 1 and the secured inner piece 2. The scraper 3 scrapes the powder compressed between the inner piece 2 and the casing 1 from the casing 1. This apparatus can implement surface fusion, dispersion/mixing, and particle size control by applying mechanical energy to a plurality of material particles. Note that the actual operation is controlled based on the motor power and the temperature of the powder particles on the inner piece.

The rotational speed of the casing 1 and the clearance S between the casing 1 and the inner piece 2 are appropriately selected. When using an AM-15F mechanofusion apparatus (manufactured by Hosokawa Micron Corporation), the rotational speed is appropriately selected depending on the raw material, but is preferably 300 to 10,000 rpm, and particularly preferably 800 to 4000 rpm, and the clearance is preferably 0.1 to 10 mm, and particularly preferably 0.5 to 5 mm.

It is preferable to perform the particle size-reduction step, the classification step, and the bonding/covering step (composite production step) in a non-oxidizing atmosphere. The non-oxidizing atmosphere may be a nitrogen gas atmosphere, an argon gas atmosphere, or a mixture thereof.

When using the melt-mixing method, a flask is charged with a material mixture. After replacing the atmosphere inside the flask with nitrogen, the material mixture is heated to a temperature equal to or higher than the melting point of the material having the lowest melting point using a mantle heater or the like, and heated at the above temperature for 3 to 4 hours with stirring. The material mixture is then cooled to obtain a molten composite material. It is preferable that the heating temperature be as low as possible so that thermal decomposition of the material does not occur. !t is preferable that the heating temperature be in the range between the melting point of the material having the lowest melting point and a temperature higher than the melting point of the material having the lowest melting point by 20°C. It is more preferable that the heating temperature be in the range between a temperature higher than the melting point of the material having the lowest melting point by 5°C and a temperature higher than the melting point of the material having the lowest melting point by 15°C.
When the melting point of the host is lower than the melting point of the dopant, the heating temperature may be set to a temperature higher than the melting point of the host. The material mixture may or may not be heated to a temperature higher than the melting point of the dopant.
The material mixture is then cooled, and allowed to stand at room temperature to obtain a viscous solid. The solid is then ground to obtain a powder. The solid may be manually ground using a mortar, or may be ground using a grinder.

When the melting point of the host is lower than the melting point of the dopant, and the material mixture is heated at a temperature between the melting point of the host and the melting point of the dopant, a composite material as shown in FIG. 1D is obtained.
When the melting point of the host is close to the melting point of the dopant, a composite material as shown in FIG. 1F in which the host and the dopant are mixed is obtained.
When heating the material mixture at a temperature around the melting point of host while maintaining part of the crystal state, a composite material as shown in FIG. 1E is obtained. It is preferable that the host material and the doping material have a melting point of 100 to 500°C when using the melt-mixing method. It is more preferable that the host material and the doping material have a melting point of 200 to 300°C.

Part or all of the materials may be dissolved in a solvent when mixing the materials. For example, a flask is charged with the material mixture. After the dropwise addition of a solvent, the mixture is stirred. A poor solvent is then added dropwise to the mixture to obtain a composite material. A solvent that dissolves one of the materials, or a solvent that dissolves each of the materials may be used.

### <Determination of production of composite material>

The expression "strongly bonded" means that the materials maintain a bonded state without being easily separated into particles. Therefore, whether or not a plurality of materials are bonded may be determined by extracting one particle having a particle size almost equal to the average particle size of the composite organic EL material, and determining whether or not the concentration ratio of the second material to the first material in the particle is almost equal to the mixing ratio of the second material to the first material before the bonding or covering step. The expression "almost equal to the mixing ratio of the second material to the first material before the bonding or covering step" means that the concentration ratio is within ±10% of the mixing ratio of the second material to the first material before the bonding or covering step. The expression "almost equal to the mixing ratio of the second material to the first material before the bonding or covering step" preferably means that the concentration ratio is within ±5% of the mixing ratio of the second material to the first material before the bonding or covering step. A particle size almost equal to the average particle size refers to a particle size within ±10 µm from the average particle size. The concentration ratio may be determined by HPLC or the like.
The concentration ratio may also be determined by the following operation. Specifically, about ten particles having a particle size almost equal to the average particle size are extracted, and the concentration of the particles is measured. This operation is repeated three times, and whether or not the concentration ratio is almost equal to the mixing ratio before the bonding or covering step is determined. This method is effective when the concentration of a small amount (number) of particles cannot be accurately measured.
Whether or not the first material is covered with the second material may be determined by extracting one particle having a particle size almost equal to the average particle size of the composite organic EL material, and determining whether or not the emission color of the second material is observed in 60% or more of the total area of the particle using a fluorescence microscope. It is preferable that the emission color of the second material be observed in 80% or more of the total area of the particle. In this case, a photograph obtained using a fluorescence microscope is processed to binarize the area corresponding to the luminescence of each material, and the area ratio of the two areas in the image is calculated.

### (4) Organic EL device

FIG. 4 schematically shows an organic EL device. Reference numeral 1 indicates a substrate. The substrate is normally formed of a glass or plastic sheet or film. Reference numeral 2 indicates an anode, reference numeral 3 indicates an organic thin film layer that includes an emitting layer, and reference numeral 4 indicates a cathode. The organic EL device includes the anode 2, the organic thin film layer 3, and the cathode 4. The organic thin film layer 3 may include a hole injecting layer or a hole transporting layer between the anode 2 and the emitting layer, or may include an electron injecting layer or an electron transporting layer between the cathode 4 and the emitting layer. A carrier blocking layer (hole blocking layer or electron blocking layer) or the like may also be provided, as required.

The substrate (indicated by reference numeral 1 in FIG. 4) is described below.
The substrate is a member that supports the organic EL device. The material for the substrate is not particularly limited. For example, an electrical insulating quartz sheet, glass sheet, plastic sheet or film, metal thin film, or the like may be used as the material for the substrate. The substrate may be transparent or opaque. It is preferable that the substrate be transparent when outcoupling light through the substrate. A transparent substrate is preferably formed of glass, quartz, a transparent plastic film, or the like.

It is preferable that the surface of glass or quartz be a photomask-grade polished surface. It is preferable to use quartz or glass having a low alkali content and a high volume resistivity (10⁷ Ωm or more at 350°C).
The thickness of the substrate is about 0.01 to 10 mm, and preferably about 0.1 to 5 mm. A flexible substrate may be used depending on the application.

Specific examples of the material for the plastic sheet or film include polyolefins such as polyethylene and polypropylene, polyesters such as polyethylene terephthalate and polyethylene naphthalate, cellulose esters such as cellulose diacetate, cellulose triacetate, cellulose acetate butyrate, cellulose acetate propionate, cellulose acetate phthalate, and cellulose nitrate, derivatives thereof, polymethyl methacrylate, polyetherketone, polyethersulfone, polyphenylene sulfide, polyetherimide, polyether ketone imide, fluororesins, nylon, polystyrene, polyallylates, polycarbonates, polyurethanes, acrylic resins, polyacrylonitrile, polyvinyl acetal, polyamides, polyimides, diacryl phthalate resins, polyvinyl acetate, polyvinyl chloride, polyvinylidene chloride, copolymers thereof, cycloolefin resins, and the like. A fluorine-based polymer compound having a low water vapor transmission rate (e.g., polyvinyl fluoride, polychlorotrifluoroethylene, or polytetrafluoroethylene) is particularly preferable as the material for the plastic sheet or film. The plastic film may have a single layer structure or a multi-layer structure.

it is necessary to take the gas barrier capability into account when using the plastic sheet or film. If the gas barrier capability of the substrate is too low, the organic EL device may deteriorate due to air that has passed through the substrate. Therefore, it may be preferable to form a dense silicon oxide film or the like on the substrate formed of a plastic sheet or film in order to provide the substrate with a gas barrier capability.
A flexible organic EL panel can be obtained by utilizing the plastic sheet or film as the substrate. Moreover, disadvantages (i.e., heaviness, low crack (breakage) resistance, and a difficulty in implementing a large panel) of an organic EL panel can be eliminated.

The anode (indicated by reference numeral 2 in FIG. 4) is described below.
A metal, an alloy, or a conductive compound having a large work function, or a mixture thereof, is preferably used as the material (electrode material) for the anode. Specific examples of such an electrode material include metals such as aluminum, gold, silver, nickel, palladium, and platinum, metal oxides such as indium tin oxide (ITO), SnO₂ and ZnO, metal halides such as copper iodide, carbon black, and conductive transparent materials such as conductive polymers such as poly(3-methylthiophene), polypyrrole, and polyaniline.

It is also possible to use an amorphous material that can produce a transparent conductive film (e.g., In₂O₃-ZnO). The anode may be produced by forming a thin film by deposition, sputtering, or the like using the above electrode material, and forming a pattern having a desired shape by photolithography. When a high patterning accuracy is not so required (about 100 µm or more), a pattern may be formed via a mask having a desired shape when depositing or sputtering the electrode material. When using a substance that can be applied (e.g., organic conductive compound), a wet deposition method (e.g., printing or coating) may also be used. The thickness of the anode is appropriately determined depending on the material in order to control the transmittance, the resistance, and the like, but is normally 500 nm or less, and preferably 10 to 200 nm.

The organic thin film layer (indicated by reference numeral 3 in FIG. 4) is described below.
The organic thin film layer is sandwiched between the anode and the cathode, and includes a hole injecting layer, a hole transporting layer, an emitting layer, a hole blocking layer, and an electron transporting layer, for example.

An emitting material including in the emitting layer of the organic thin film layer is not particularly limited. Examples of a host material or a doping material include polycyclic aromatic compounds such as anthracene compounds, phenanthrene compounds, fluoranthene compounds, tetracene compounds, triphenylene compounds, chrysene compounds, pyrene compounds, coronene compounds, perylene compounds, phthaloperylene compounds, naphthaloperylene compounds, naphthacene compounds, pentacene compounds, and periflanthene compounds, oxadiazole, bisbenzoxazoline, bisstyryl, cyclopentadiene, quinoline metal complexes, tris(8-hydroxyquinolinato)aluminum complexes, tris(4-methyl-8-quinolinato)aluminum complexes, a tris(5-phenyl-8-quinolinato)aluminum complex, aminoquinoline metal complexes, benzoquinoline metal complexes, tri(p-terphenyl-4-yl)amine, 1-aryl-2,5-di(2-thienyl)pyrrole derivatives, pyran, quinacridon, rubrene, distyrylbenzene derivatives, distyrylarylene derivatives, porphyrin derivatives, stilbene derivatives, pyrazoline derivatives, coumarin dyes, pyran dyes, phthalocyanine dyes, naphthalocyanine dyes, croconium dyes, squarylium dyes, oxobenzanthracene dyes, fluoresceine dyes, rhodamine dyes, pyrylium dyes, perylene dye, stilbene dyes, polythiophene dyes, rare-earth complex fluorescent materials, rare-earth phosphorescent complexes (e.g., Ir complex), polymer materials such as conductive polymers such as polyvinyl carbazole, polysilanes, and polyethylenedioxythiophene (PEDOT), and the like. These compounds may be used either individually or in combination.
The host material and the doping material are selected from these compounds. Examples of a preferable host material include diarylanthracene derivatives and diarylnaphthacene derivatives. Examples of a preferable doping materials include aromatic amine compounds and styrylamine compounds. The anode preferably includes the host material in an amount of 70 to 99.5 wt%, and includes the doping material in an amount of 0.5 to 30 wt%.

The thickness of the emitting layer is normally 0.5 to 500 nm, and preferably 0.5 to 200 nm.

The emitting layer may be deposited by flash evaporation using the composite material according to one embodiment of the invention that includes the host material and the doping material. The organic thin film layer may include a plurality of emitting layers. In this case, each of the plurality of emitting layers may be formed by flash evaporation, or only some of the plurality of emitting layers may be formed by flash evaporation.

Materials that may normally be used for an organic EL device may be used as the materials for the hole injecting layer, the hole transporting layer, and the carrier blocking layer. Specific examples of such a material include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, polysilanes, aniline copolymers, conductive oligomers, and the like. Materials that may normally be used for an organic EL device may be used as the material for the electron transporting layer. For example, 8-hydroxyquinoline, a metal complex of an 8-hydroxyquinoline derivative, an oxadiazole derivative, or a nitrogen-containing heterocyclic derivative may suitably be used. Specific examples of the metal complex of an 8-hydroxyquinoline derivative include metal chelate oxinoid compounds including a chelate of oxine (8-quinolinol or 8-hydroxyquinoline), such as tris(8-quinolinol)aluminum. These layers may have a thickness normally employed for an organic EL device, and may be formed by a method normally employed for an organic EL device. The composite organic EL material according to one embodiment of the invention may suitably be used when the hole injecting layer, the hole transporting layer, and the carrier blocking layer are formed of a plurality of materials.

The cathode (indicated by reference numeral 4 in FIG. 4) is described below.
A metal, an alloy, or an electrically conductive compound having a small work function, or a mixture thereof, is preferably used as the material (electrode material) for the cathode. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, an aluminum/lithium fluoride mixture, rare earth metals, and the like. For example, the cathode may be formed by forming a thin film on the organic thin film layer by vacuum deposition, sputtering, or the like using the above electrode material. The thickness of the cathode is determined depending on the material, but is normally 1 µm or less, and preferably 1 to 500 nm.

The emitting layer of the organic EL device emits light when causing a current to flow through the organic EL device. The thickness of the organic EL device is normally 1 µm or less. One or more organic EL devices may be sandwiched between the anode and the cathode. Light is outcoupled through the anode or the cathode. In FIG. 4, the anode 2 and the cathode 4 may be replaced by each other.

### EXAMPLES

### Example 1

A host material H1 (first material) and a doping material D1 (second material) were used in a ratio of 92.5:7.5 (wt%). An anthracene derivative having a melting point of 273°C and a molecular weight of 506 was used as the host material H1. An arylamino group-containing fused aromatic derivative having a melting point of 458°C and a molecular weight of 956 was used as the doping material D1. The predominant emission peak wavelength of the host material H1 was 422 nm, and the predominant emission peak wavelength of the doping material D1 was 507 nm.

The host material was ground at 13,600 rpm using a grinder ("Fine Impact Mill 100UPZ" manufactured by Hosokawa Micron Corporation). The doping material was also ground at 13,600 rpm using the above grinder. The host material was classified using a multiplex (Zig-Zag Classifier manufactured by Hosokawa Alpine) to remove particles having a particle size of 10 µm or less. The particle content (wt%) was measured using a laser diffraction particle size distribution analyzer (Microtrac MT-3300EXII). The average particle size of the host material was 34 µm, and the average particle size of the doping material was 29.4 µm. A composite material of the host material and the doping material was produced using a mechanofusion apparatus (manufactured by Hosokawa Micron Corporation) (3000 rpm).

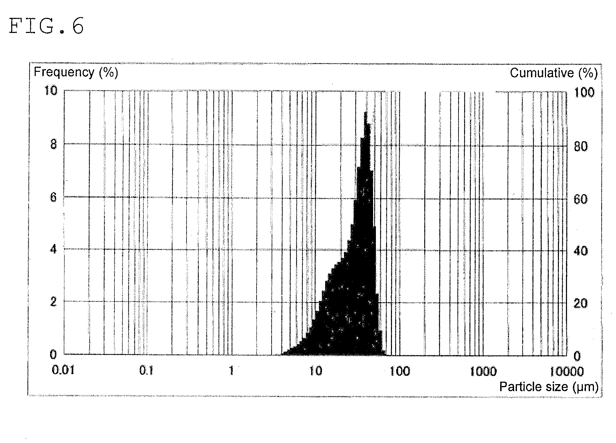

The average particle size of the resulting composite organic EL material powder, and the content (wt%) of particles having a particle size of 10 µm or less were measured using a laser diffraction particle size distribution analyzer (Microtrac MT-3300EXII). FIG. 6 shows the particle size distribution. The particle size standard deviation was 13.7. Five samples (about 1 mg) were collected from different points of the composite organic EL material. The dopant concentration (doping material compositional ratio) was determined by HPLC, and the standard deviation of the dopant concentrations of the five samples was determined. The results are shown in Tables 1 and 2. The dopant concentration in arbitrarily sampled particles determined by HPLC was 7.64%, 7.57%, 7.58%, 7.63%, and 7.67%, respectively. The change (variation) from the mixing ratio was -1.9%, 0.9%, -1.1%, -1.7%, and -2.3% (i.e., within ±5%).

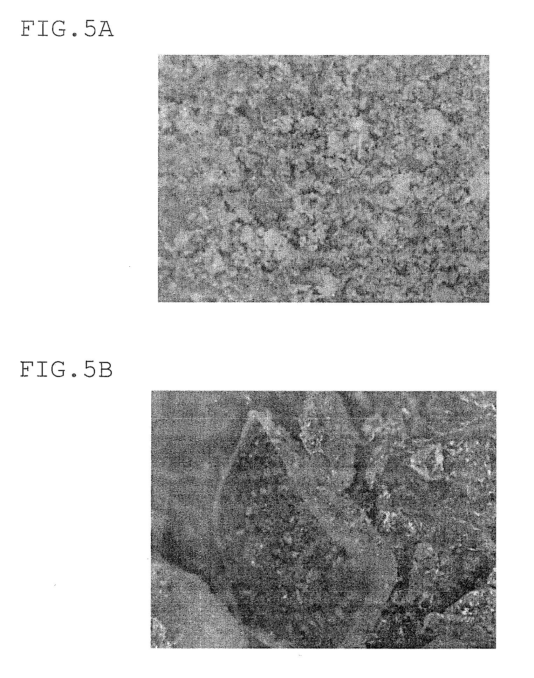

FIG. 5A shows a photograph of the resulting composite organic EL material. A brown area in the photograph indicates the dopant (i.e., the host is covered with the dopant).
The image was photographed using a microscope "DZ3" and an objective lens "ZC50" (manufactured by Union Optical Co., Ltd.). A still image was obtained using a 3CCD color video camera "DXC-390" (manufactured by SONY Corporation). The composite organic EL material was also photographed using an excitation filter (420 to 490 nm) and an eyepiece absorption filter (520 nm or more) utilizing the above device. A blue region corresponding to the emission wavelength of the host and a green region corresponding to the emission wavelength of the dopant were binarized by processing the resulting photograph. The area ratio of the blue region to the green region was 17:83. Specifically, the emission color of the doping material D1 was observed in 80% or more of the total area.

### Example 2

A flask was charged with the host material H1 (92.5 wt%) and the doping material D1 (7.5 wt%) used in Example 1. The materials were melt-mixed at 350°C for 4 to 5 hours using a mantle heater. The mixture was allowed to stand at room temperature, and ground using a mortar to obtain an organic EL material. The measurement results are shown in Table 1.
FIG. 5B shows a photograph of the resulting composite organic EL material. The host particles and the dopant particles were present in the composite organic EL material in a dispersed state (see FIG. 1F).

### Comparative Example 1

A host material H1 (first material) and a doping material D1 (second material) were used in a ratio of 92.5:7.5 (wt%). The host material H1 and the doping material D1 were separately ground. The host material H1 and the doping material D1 were not classified. The average particle size of the host material H1 was 73 µm, and the average particle size of the doping material D1 was 10 µm. The host material H1 and the doping material D1 were mixed without using a mechanofusion apparatus. The measurement results are shown in Table 1.
The resulting composite organic EL material was photographed using an excitation filter (420 to 490 nm) and an eyepiece absorption filter (520 nm or more) utilizing the above device. A blue region corresponding to the emission wavelength of the host and a green region corresponding to the emission wavelength of the dopant were binarized by processing the resulting photograph. The area ratio of the blue region to the green region was 93:7. Specifically, the emission color of the doping material D1 was observed in less than 60% of the total area.

In Example 1 in which the host material H1 and the doping material D1 were mixed by the mechanofusion method, and Example 2 in which the host material H1 and the doping material D1 were melt-mixed, a variation (standard deviation) in dopant concentration was smaller than that of the material mixture of Comparative Example 1. Therefore, it is considered that the change in compositional ratio of the composite material discharged from the screw section during flash evaporation was small. When melt-mixing the host material H1 and the doping material D1, a variation in dopant concentration was even smaller than in the case of mixing the host material H1 and the doping material D1 by the mechanofusion method. Therefore, it is considered that the change in compositional ratio of the composite material discharged from the screw section during flash evaporation was reduced by utilizing the melt-mixing method.

### Example 3

A compound H2 and a compound D2 were respectively used as a host material and a doping material in a ratio of 99:1 (wt%). The compound H2 was a naphthacene derivative having a melting point of 370°C and a molecular weight of 684. The compound D2 was a periflanthene derivative having a melting point of 310°C and a molecular weight of 956.
The compound H2 and the compound D2 were ground, and mixed using a mechanofusion apparatus (3000 rpm). The measurement results are shown in Table 1.

### Example 4

An organic EL material was produced in the same manner as in Example 3, except for mixing the compound H2 and the compound D2 using a mechanofusion apparatus at 7000 rpm. The measurement results are shown in Table 1.

### Comparative Example 2

An organic EL material was produced in the same manner as in Example 3, except for mixing the compound H2 and the compound D2 without using a mechanofusion apparatus. The measurement results are shown in Table 1.

When using the compound H2 and the compound D2 as the host material and the doping material, respectively, a variation in dopant concentration was almost the same as that obtained when using the host material H1 and the doping material D1. Therefore, when using a material produced using the mechanofusion method, it is considered that the change in compositional ratio of the composite material discharged from the screw section during flash evaporation was reduced as compared with the case of using a material produced without using the mechanofusion method. It is considered that adhesion between the host and the dopant increased when setting the rotational speed of the mechanofusion apparatus to 7000 rpm as compared with the case of setting the rotational speed of the mechanofusion apparatus to 3000 rpm. A variation in dopant concentration was small when setting the rotational speed of the mechanofusion apparatus to 7000 rpm. Therefore, it is considered that the change in compositional ratio of the composite material discharged from the screw section during flash evaporation was reduced by setting the rotational speed of the mechanofusion apparatus to 7000 rpm. Note that it is considered that the material mixture of the compound H2 and the compound D2 had poor fluidity due to a small particle size.

### Example 5

An organic EL material was produced in the same manner as in Example 1, except that the host material H1 was not classified (i.e., particles having a particle size of 10 µm or less were not removed) after grinding. Table 2 shows the measurement results for the content (wt%) of particles having a particle size of 10 µm or less.
In Example 1, the content of particles having a particle size of 10 µm or less in the composite material was reduced to 5.8 vol% by classification. In Example 5, the content of particles having a particle size of 10 µm or less in the composite material was relatively high since the host material H1 was not classified.

The specific energy, the angle of internal friction, and the adhesion of the composite material were measured using a powder fluidity analyzer "Powder Rheometer FT4" (manufactured by Sysmex "corporation). The results are shown in Table 2.

The specific energy is the energy value required for the powder to flow. The specific energy obtained in Example 5, in which the content of particles having a particle size of 10 µm or less was higher than that of Example 1, was higher than that of Example 1.
The angle of internal friction is the shear strength of the powder that changes in proportion to the load. The angle of internal friction obtained in Example 5, in which the content of particles having a particle size of 10 µm or less was higher than that of Example 1, was higher than that of Example 1.
The adhesion is an index of the degree by which the compressed powder is bonded. The adhesion obtained in Example 5, in which the content of particles having a particle size of 10 µm or less was higher than that of Example 1, was higher than that of Example 1.
Specifically, the composite material of Example 5 had a fluidity lower than that of the composite material of Example 1. Therefore, it is considered that the change in compositional ratio of the composite material discharged from the screw section during flash evaporation was reduced when using the composite material of Example 1.

**TABLE 1**

| Example | Host | Dopant | Mixing ratio | Bonding method | Average particle size | Variation in dopant concentration |
|---|---|---|---|---|---|---|
| | | | wt% | | µm | Standard deviation (%) |
| Example 1 | H1 | D1 | 92.5/7.5 | mechanofusion (3000 rpm) | 31 | 0.10 |
| Example 2 | H1 | D1 | 92.5/7.5 | Melt-mixing | 79 | 0.07 |
| Comparative Example 1 | H1 | D1 | 92.5/7.5 | - | 34 | 0.43 |
| Example 3 | H2 | D2 | 99/1 | Mechanofusion (3000 rpm) | 23 | 0.13 |
| Example 4 | H2 | D2 | 99/1 | Mechanofusion (7000 rpm) | 26 | 0.08 |
| Comparative Example 2 | H2 | D2 | 99/1 | - | 20 | 0.20 |

**TABLE 2**

| | Example 1 | Example 5 |
|---|---|---|
| Particles having particle size of 10 µm or less (vol%) | 5.8 | 20.7 |
| Specific energy (mJ/g) | 6.30 | 7.20 |
| Angle of internal friction (°) | 26.0 | 26.1 |
| Adhesion (KPa) | 0.94 | 1.63 |

### INDUSTRIAL APPLICABILITY

The composite organic EL material according to the invention may be used to produce an organic EL device (particularly an emitting layer of an organic EL device).

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.
The documents described in the specification are incorporated herein by reference in their entirety.

## Claims

1. A composite organic electroluminescent material comprising particles that include two or more materials, the two or more materials being bonded and including a first material and a second material.

2. The composite organic electroluminescent material according to claim 1, wherein the first material is covered with the second material.

3. The composite organic electroluminescent material according to claim 1 or 2, wherein the first material is a host material, and the second material is a doping material.

4. The composite organic electroluminescent material according to any one of claims 1 to 3, wherein the first material is selected from anthracene derivatives and naphthacene derivatives, and the second material is selected from aromatic amine derivatives, periflanthene derivatives, and pyrromethene derivatives.

5. The composite organic electroluminescent material according to any one of claims 1 to 4, the composite organic electroluminescent material having an average particle size of 20 to (540-3σ) µm wherein σ is the standard deviation of the particle size distribution of the composite organic electroluminescent material.

6. The composite organic electroluminescent material according to claim 5, the composite organic electroluminescent material having an average particle size of 20 to (200-3σ) µm wherein σ is the standard deviation of the particle size distribution of the composite organic electroluminescent material.

7. The composite organic electroluminescent material according to any one of claims 1 to 4, the composite organic electroluminescent material having an average particle size of 20 to 80 µm.

8. The composite organic electroluminescent material according to any one of claims 1 to 7, the composite organic electroluminescent material including particles having a particle size of 10 µm or less in an amount of 10 wt% or less.

9. A method of producing a composite organic electroluminescent material comprising reducing a particle size of two or more materials including a first material and a second material, and bonding the two or more materials to obtain particles.

10. A method of producing a composite organic electroluminescent material comprising reducing a particle size of a first material and a second material, and covering the first material with the second material.

11. The method according to claim 10, wherein the average particle size of the second material is reduced to 3 to 30 µm.

12. The method according to claim 10 or 11, wherein the first material is covered with the second material using a mechanofusion method.

13. The method according to any one of claims 9 to 12, further comprising classifying the first material that has been reduced in particle size so that the first material includes particles having a particle size of 10 µm or less in an amount of 10 wt% or less.

14. A deposition method comprising depositing a film using the composite organic electroluminescent material according to any one of claims 1 to 8.
